# EUROPÄISCHE PATENTSCHRIFT

(11) **EP 2 737 552 B1**
(45) Veröffentlichungstag und Bekanntmachung des Hinweises auf die Patenterteilung: **03.02.2016**
(21) Anmeldenummer: 12742825.8
(22) Anmeldetag: 16.07.2012
(51) Int. Cl.: H01L 41/047, H01L 41/083, H01L 41/09, H01L 41/113, H01L 41/193, H01L 41/27

(54) **VERFAHREN ZUR HERSTELLUNG BIEGBARER EAP-GENERATOREN**
METHOD FOR PRODUCING FLEXIBLE EAP GENERATORS
PROCÉDÉ DE FABRICATION DE GÉNÉRATEURS EAP FLEXIBLES

(30) Priorität: 29.07.2011 DE 102011080128
(43) Veröffentlichungstag der Anmeldung: 04.06.2014
(73) Patentinhaber: Robert Bosch GmbH, 70442 Stuttgart (DE)
(72) Erfinder: DENES, Istvan, 71336 Waiblinge/Hohenacker (DE)
(86) Internationale Anmeldenummer: PCT/EP2012/063879
(87) Internationale Veröffentlichungsnummer: WO 2013/017399

(56) Entgegenhaltungen:
- WO-A1-2007/029275
- WO-A2-2009/135328
- DE-A1-102009 054 035
- DE-C1- 19 938 456
- US-A1- 2004 217 671
- US-B2- 6 664 718

## Beschreibung

### Stand der Technik

Elektroaktive Polymere (EAP) sind Polymere, die ihre Form durch das Anlegen einer elektrischen Spannung verändern. Daher können elektroaktive Polymere als Aktoren verwendet werden. Elektroaktive Polymere ermöglichen aber auch einen generatorischen Betrieb, bei dem eine mechanisch verursachte Dehnung des elektroaktiven Polymers direkt in elektrische Energie umgewandelt wird. Derartige Energiewandler werden als EAP-Generatoren bezeichnet. Die Umwandlung der Dehnung des elektroaktiven Polymers in elektrische Energie erfolgt auf kapazitiver Basis durch Verschieben von Landungen. Bei der Umwandlung mechanischer Energie in elektrische Energie mittels elektroaktiver Polymere wird der EAP-Generator, umfassend mindestens ein Bauelement, das zwei nachgiebige Elektroden umfasst, zwischen denen eine Schicht aus elektroaktivem Polymer angeordnet ist, aufgrund einer äußeren Krafteinwirkung gedehnt. Im Zustand maximaler Dehnung des EAP-Generators wird das elektroaktive Polymer mit elektrischen Ladungen unterhalb der Durchbruchsfeldstärke beaufschlagt. Bei Verringerung der äußeren Krafteinwirkung entspannt sich das elektroaktive Polymer aufgrund seiner Elastizität. In dieser Phase erhöht sich die im EAP-Generator gespeicherte Energie. Dieser Vorgang stellt die eigentliche Umwandlung der mechanischen in die elektrische Energie dar. Sobald der EAP-Generator vollständig entspannt ist, wird das mit elektrischer Ladung beaufschlagte elektroaktive Polymer entladen, wodurch der EAP-Generator wieder seine Ausgangslänge erreicht. Der Energiegewinnungszyklus kann erneut beginnen.

EAP-Generatoren können mehrere Lagen, jeweils umfassend zwei Elektroden zwischen denen eine Schicht aus elektroaktivem Polymer angeordnet ist, aufweisen, wobei die Lagen zu einem Stapel oder zu mehreren Stapeln zusammengefasst sind. Diese Stapel werden als EAP-Stapel bezeichnet. Für die vorliegende Erfindung werden unter dem Begriff EAP-Stapel aber auch Ausführungsformen verstanden, die nur eine Lage aus zwei Elektroden mit einer dazwischen liegenden Schicht aus elektroaktivem Polymer aufweisen. EAP-Stapel im Sinne der vorliegenden Erfindung sind daher Stapel, die mindestens eine Lage, umfassend zwei vorzugsweise flexible Elektroden und eine zwischen den beiden Elektroden angeordnete Schicht aus elektroaktivem Polymer, aufweisen.

Aus dem Stand der Technik sind verschiedene Verfahren zur Herstellung von EAP-Stapeln bekannt. Ein Verfahren besteht darin, einzelne Lagen, umfassend zwei Elektroden zwischen denen eine Schicht aus elektroaktivem Polymer angeordnet ist, übereinander zu legen und anschließend von außen miteinander zu verdrahten.

Ein EAP-Generator und ein Verfahren zur Herstellung von EAP-Stapeln sind beispielsweise aus der DE 10 2009 054 035 A1 bekannt.

DE 199 38 456 C1 beschreibt einen schraubenförmig aufgebauten Aktor mit durchgehenden Elektroden.

Die mit den bekannten Verfahren hergestellten EAP-Stapel können als Aktuator oder als Generator verwendet werden. Allerdings sind diese EAP-Stapel nur bei einer Verformung in Richtung ihrer Längsachse wirksam, nicht aber bei einer Biegung.

US 2004/217671 A1 zeigt einen in Längsrichtung spiralförmig aufgebauten Aktor für Biegebewegungen.

### Offenbarung der Erfindung

Mit der vorliegenden Erfindung wird ein Verfahren zur Herstellung von EAP-Generatoren beziehungsweise von EAP-Stapeln bereit gestellt, die elektrische Energie aus Biegungsbewegungen erzeugen können und durch Beaufschlagung mit elektrischer Energie bewegbar sind, insbesondere biegbar. Ferner werden EAP-Generatoren beziehungsweise EAP-Stapel bereitgestellt, die elektrische Energie aus Biegungen der in ihnen enthaltenen EAP-Stapel erzeugen können und die durch Beaufschlagung mit elektrischer Energie bewegbar sind, insbesondere biegbar. In einem weiteren Aspekt betrifft die vorliegende Erfindung die Verwendung der EAP-Generatoren bzw. EAP-Stapel zur Erzeugung von elektrischer Energie aus Bewegungsenergie, insbesondere aus der Energie von Biegebewegungen. Die vorliegende Erfindung stellt auch Verfahren zur Erzeugung elektrischer Energie aus dem Verbiegen von EAP-Stapeln bereit. Ferner betrifft die vorliegende Erfindung auch die Verwendung der erfindungsgemäßen EAP-Generatoren und EAP-Stapel als Aktuatoren.

In einem ersten Aspekt wird mit der vorliegenden Erfindung ein Verfahren zur Herstellung von EAP-Generatoren, die mindestens einen EAP-Stapel aufweisen, oder von EAP-Stapeln bereitgestellt, die elektrische Energie aus Biegungsbewegungen erzeugen können und durch Beaufschlagung mit elektrischer Energie bewegbar sind, insbesondere biegbar. Damit EAP-Generatoren die mechanische Energie von Biegebewegungen in elektrische Energie umwandeln können, ist eine Unterteilung der Elektroden in zumindest zwei Sektoren, bezogen auf den Querschnitt des bzw. der EAP-Stapel, erforderlich. Das erfindungsgemäße Verfahren zeichnet sich dadurch aus, dass ein flacher Streifen, umfassend eine Lage eines elektroaktiven Polymers und auf diese Lage abschnittweise aufgebrachte Elektroden, derart schraubenförmig aufgewickelt wird, dass mehrere Elektroden deckungsgleich übereinander angeordnet werden, wobei jeweils zwei übereinander angeordnete Elektroden von zumindest einer Lage elektroaktiven Polymers voneinander getrennt sind. Hierbei sind die deckungsgleich übereinander angeordneten Elektroden keine in Bezug auf den Streifen unmittelbar benachbarte Elektroden.

Die einzelnen Windungen der aus dem Aufwickeln resultierenden Schraube werden miteinander verbunden oder zusammen gehalten. Dazu können jeweils zwei unmittelbar aufeinander folgende Windungen miteinander verklebt, verschweißt oder versiegelt werden. Es ist aber auch möglich, die schraubenförmigen Stapel in eine flexible Hülle, beispielsweise in einen Schlauch, einzubringen und diese an ihren gegenüberliegenden Enden zu verschließen, so dass eine Spaltbildung zwischen den einzelnen Windungen des EPA-Stapels vermieden wird. Die letztgenannte Ausführungsform hat den Vorteil, dass der EAP-Stapel vor schädlichen Einflüssen der Umwelt geschützt ist.

Der für das erfindungsgemäße Verfahren verwendete Streifen umfasst eine Lage aus elektroaktivem Polymer, und eine diskontinuierliche Lage aus Elektroden, die auf eine der beiden einander gegenüberliegenden Oberflächen der Lage aus elektroaktivem Polymer aufgebracht sind. Die Elektroden können durch Drucken, Vakuumabscheidung oder andere Beschichtungsverfahren abschnittweise auf der einen Oberfläche der streifenförmigen Lage aus elektroaktivem Polymer aufgebracht sein.

Die Wicklung des Streifens erfolgt derart, dass jede Windung der sich durch das schraubenförmige Aufwickeln des Streifens ergebenden Schraube mindestens zwei unmittelbar aufeinander folgende, auf die Lage aus elektroaktivem Polymer abschnittweise aufgebrachte Elektroden aufweist. Somit weist jede Windung der hergestellten Schraube mindestens zwei separate Elektroden auf. Vorzugsweise wird der Streifen derart zu einer Schraube gewickelt, dass die Schraube drei oder vier separate Elektroden je Windung aufweist. Das bedeutet, dass jede zweite, vorzugsweise jede dritte oder jede vierte der auf der Lage aus elektrokativem Polymer aufgebrachten Elektroden im EAP-Stapel deckungsgleich übereinander angeordnet ist. Es ist aber auch möglich, mehr Elektroden pro Windung vorzusehen. Die einzelnen Elektroden repräsentieren daher Ringsegmente im Querschnitt der Schraube. Die Gesamtheit der in der Schraube deckungsgleich übereinander angeordneten Elektroden repräsentiert somit einen Zylinder- oder Ringsektor. Insofern umfasst ein EAP-Stapel mit zwei Elektroden je Windung zwei Zylinder- oder Ringsektoren, ein EAP-Stapel mit drei Elektroden je Windung drei Zylinder- oder Ringsektoren, und ein EAP-Stapel mit vier Elektroden je Windung vier Zylinder- oder Ringsektoren. Bei dem Verfahren erfolgt die Wicklung des Streifens derart, dass jede zweite, dritte oder vierte Elektrode des Streifens im Stapel deckungsgleich übereinander angeordnet wird.

Die für das erfindungsgemäße Verfahren verwendeten Streifen weisen nur auf einer Seite der streifenförmigen Lage aus elektroaktivem Polymer eine diskontinuierliche Beschichtung mit flexiblen, flächenförmigen Elektroden. Durch das schraubenförmige Aufwickeln des Streifens wird eine Schraube erzeugt, bei der die auf die Lage elektroaktiven Polymers aufgebrachten Elektroden einer Windung mit der Lage elektroaktiven Polymers der folgenden Windung in Kontakt gebracht werden. Daher repräsentieren, bezogen auf jede einzelne Windung der Schraube, die auf die streifenförmige Lage aus elektroaktivem Polymer aufgebrachten Elektroden die Signalelektroden für die Bereiche des elektroaktiven Polymers, auf die sie aufgebracht sind und die Masseelektroden für die Bereiche des elektroaktiven Polymers der folgenden Windung, mit denen sie durch das Aufwinden in Kontakt gebracht wurden. Jede der Elektroden im EAP-Stapel fungiert daher gleichzeitig als Masseelektrode für einen Abschnitt der streifenförmigen Lage aus elektroaktivem Polymer und als Signalelektrode für einen anderen Abschnitt der streifenförmigen Lage aus elektroaktivem Polymer. Das elektroaktive Polymer ist nicht elektrisch leitend, so dass es nicht zu einem Kurzschluss zwischen der Masseelektrode und der Signalelektrode des gleichen Segments kommt.

Um die Integrität und Funktionalität der Ring- oder Zylindersektoren im EAP-Stapel zu gewährleisten, ist ein genaues übereinander Anordnen der Elektroden wichtig, denn nur bei präziser deckungsgleicher Anordnung der Elektroden übereinander kann die Biegung des EAP-Stapels effizient in elektrische Energie umgewandelt werden. Um das zu erreichen wird der Streifen bei einer bevorzugten Ausführungsform des erfindungsgemäßen Verfahrens um einen Stab gewickelt. In der einfachsten Ausführungsform weist der Stab einen kreisrunden oder ovalen Querschnitt auf. Vorzugsweise weist der Stab einen dreieckigen, viereckigen, mehreckigen oder sternförmigen Querschnitt auf, wobei der Streifen an seiner Seite, die den inneren Umfang der Schraube bestimmt, Auskragungen und/oder Aussparungen aufweist, die derart ausgestaltet sind, dass eine formschlüssige Wicklung des Streifens mit dem Stab und um den Stab erfolgen kann. Bei dem erfindungsgemäßen Verfahren wird der Streifen daher formschlüssig mit dem Stab um den Stab gewickelt. Die Verwendung derartiger Stäbe als Windungskern, der nach erfolgter Herstellung der Schraube aus deren Innenraum entfernt werden kann, ermöglicht eine präzise Positionierung der Elektroden.

Der Stab kann nach erfolgter Wicklung der Schraube aus deren Hohlraum entfernt werden, so dass ein im Wesentlichen röhrenförmiger EAP-Stapel hergestellt wird. Der Stab kann aber nach erfolgter Wicklung der Schraube auch in deren Hohlraum verbleiben, sofern der Stab so flexibel ist, dass die Biegbarkeit der Schraube nicht beeinträchtigt wird. Bei dieser Ausgestaltung ist der hergestellte EAP-Stapel im Wesentlichen zylinderförmig.

In einem zweiten Aspekt betrifft die vorliegende Erfindung EAP-Generatoren, umfassend mindestens einen EAP-Stapel, bzw. EAP-Stapel, der/die mit dem erfindungsgemäßen Verfahren herstellbar sind.

Die erfindungsgemäßen EAP-Stapel umfassen einen schraubenförmig aufgewickelten Streifen, der eine Lage eines elektroaktiven Polymers und auf diese Lage abschnittweise aufgebrachte Elektroden aufweist, bei dem mehrere, auf dem Streifen nicht unmittelbar benachbarte Elektroden deckungsgleich übereinander angeordnet sind, wobei jeweils zwei übereinander angeordnete Elektroden von zumindest einer Lage elektroaktiven Polymers voneinander getrennt sind.

Die erfindungsgemäßen EAP-Generatoren umfassen mindestens einen EAP-Stapel, der zwei, drei oder vier Ringsektoren aufweist, die deckungsgleich übereinander angeordnete Elektroden repräsentieren. Dementsprechend weist jede Windung eines EAP-Stapels zwei, drei oder vier separate Elektroden auf.

Die EAP-Stapel weisen einen Hohlraum auf, der sich im Zentrum der Schraube in deren Längsrichtung erstreckt. Dieser Hohlraum wird vom inneren Umfang der Schraube begrenzt. In besonderen Ausführungsformen kann die Schraube einen Stab in ihrem Hohlraum aufweisen. Der Stab kann einen kreisrunden, ovalen, dreieckigen, viereckigen, mehreckigen oder sternförmigen Querschnitt aufweisen. Vorzugsweise ist der Stab formschlüssig von der Schraube umgeben.

Die vorliegende Erfindung erstreckt sich auch auf die Verwendung von EAP-Generatoren, umfassend die mindestens einen EAP-Stapel, der einen schraubenförmig aufgewickelten Streifen umfasst, welcher eine Lage eines elektroaktiven Polymers und auf diese Lage abschnittweise aufgebrachte Elektroden aufweist, bei dem mehrere, auf dem Streifen nicht unmittelbar benachbarte Elektroden deckungsgleich übereinander angeordnet sind, wobei jeweils zwei übereinander angeordnete Elektroden von einer Lage elektroaktiven Polymers voneinander getrennt sind, zur Erzeugung elektrischer Energie, insbesondere zur Erzeugung elektrischer Energie durch Umwandlung der mechanischen Energie von Biegebewegungen des EAP-Stapels. Somit umfasst die vorliegende Erfindung auch Verfahren zur Erzeugung elektrischer Energie, indem die mechanische Energie von Biegebewegungen des EAP-Stapels in elektrische Energie umgewandelt wird.

Die vorliegende Erfindung erstreckt sich auch auf die die Verwendung von EAP-Generatoren, umfassend die mindestens einen EAP-Stapel, der einen schraubenförmig aufgewickelten Streifen umfasst, welcher eine Lage eines elektroaktiven Polymers und auf diese Lage abschnittweise aufgebrachte Elektroden aufweist, bei dem mehrere, auf dem Streifen nicht unmittelbar benachbarte Elektroden deckungsgleich übereinander angeordnet sind, wobei jeweils zwei übereinander angeordnete Elektroden von einer Lage elektroaktiven Polymers voneinander getrennt sind, als Aktuatoren, insbesondere als Aktuatoren, die eine Biegebewegung vollführen können.

Die Erfindung wird nachfolgend an Hand der Zeichnungen näher erläutert, wobei die Zeichnungen lediglich der Veranschaulichung dienen, die Erfindung aber nicht einschränken.

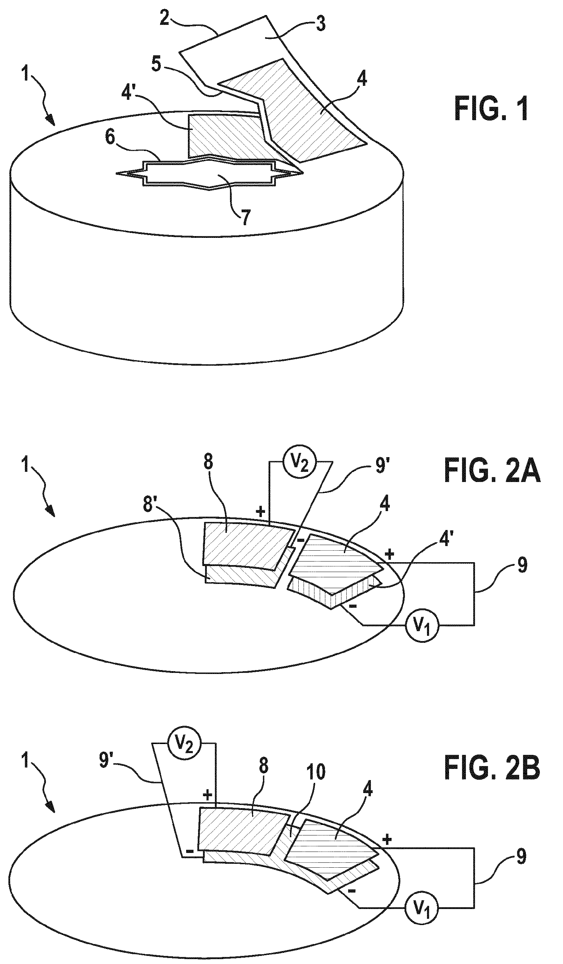

Figur 1 ist eine schematische Umrisszeichnung eines schraubenförmig aufgebauten EAP-Stapels. Der EAP-Stapel 1 basiert auf einen Streifen 2, der schraubenförmig aufgewickelt ist. Der Streifen 2 umfasst eine Lage 3 aus elektroaktivem Polymer, und auf diese Lage 3 abschnittweise aufgebrachte, flächige Elektroden 4, 4'. Der Streifen 2 ist schraubenförmig derart gewickelt, dass zwei nicht unmittelbar aufeinander folgende, flächige Elektroden 4, 4' deckungsgleich übereinander angeordnet sind, wobei eine Lage 3 aus elektroaktivem Polymer zwischen jeweils zwei deckungsgleich übereinander liegend angeordnete Elektroden angeordnet ist.

Der Umfang des dargestellten EAP-Stapels 1 ist kreisrund, er kann aber auch eine andere Querschnittsform aufweisen. Der Streifen 2 ist derart schraubenförmig gewickelt, dass ein Hohlraum 6 entsteht, der vom inneren Umfang der Schraube 1 begrenzt wird. Der Hohlraum 6 erstreckt sich in Längsrichtung des EAP-Stapels 1 entlang der Längsachse des EAP-Stapels 1. Der Hohlraum 6 weist in der dargestellten Ausführungsform keinen kreisrunden Querschnitt auf, sondern einen sternförmigen Querschnitt. Dieser sternförmige Querschnitt des Hohlraums 6 ergibt sich aus dem schraubenförmigen Wickeln des Streifens 2, der Aussparungen 5 in bestimmten Abschnitten entlang der Innenkante des Streifens 2, die den inneren Umfang der Schraube ausbilden, aufweist. Die Aussparungen 5 sind vorzugsweise in gleichmäßigen Abständen zueinander entlang der Innenkante des Streifens 2 angeordnet.

Bei der Herstellung des dargestellten EAP-Stapels 1 wird der Streifen 2 um einen in seinem Querschnitt sternförmigen Stab 7 gewickelt. Indem die Aussparungen 5 des Streifens 2 die Zacken des sternförmigen Stabs 7 formschlüssig umfassen, wird ein genaues übereinander Positionieren der flächigen Elektroden 4, 4' beim Wickeln der Schraube möglich.

Figuren 2A und 2B veranschaulichen zwei Ausführungsformen erfindungsgemäßer EAP-Stapel 1, die sich in der Ausgestaltung Ihrer Elektroden voneinander unterscheiden. In Fig. 2A und 2B ist lediglich die Oberseite eines EAP-Stapels 1 angedeutet nicht jedoch die Seite. Fig. 2A zeigt eine Ausführungsform eines EAP-Stapels 1, bei der jede der flächigen Elektroden 4, 8 einer Windung der Schraube deckungsgleich über jeweils einer separaten flächigen Elektrode 4', 8' der vorhergehenden Windung der Schraube angeordnet ist. Die zwischen den Elektroden 4, 8 und 4', 8' angeordnete Lage elektroaktiven Polymers ist nicht dargestellt. Elektrische Energie kann den jeweiligen Elektrodenpaaren aus den deckungsgleich übereinander angeordneten Elektroden 4, 4' beziehungsweise 8, 8' über separate Schaltkreise 9, 9' zugeführt beziehungsweise von diesen abgeführt werden.

Fig. 2B zeigt eine Ausführungsform eines EAP-Stapels 1, bei der zwei separate flächige Elektroden 4, 8 einer Windung der Schraube über einer flächigen Elektrode 10 der vorhergehenden Windung der Schraube angeordnet sind, wobei die gemeinsame Fläche der separaten Elektroden 4, 8 im Wesentlichen der Fläche der Elektrode 10 entspricht. Die zwischen den Elektroden 4, 8 und 10 angeordnete Lage elektroaktiven Polymers ist nicht dargestellt. Elektrische Energie kann den jeweiligen Elektrodenpaaren aus Elektroden 4,10 beziehungsweise 8,10 über separate Schaltkreise 9, 9' zugeführt beziehungsweise von diesen abgeführt werden.

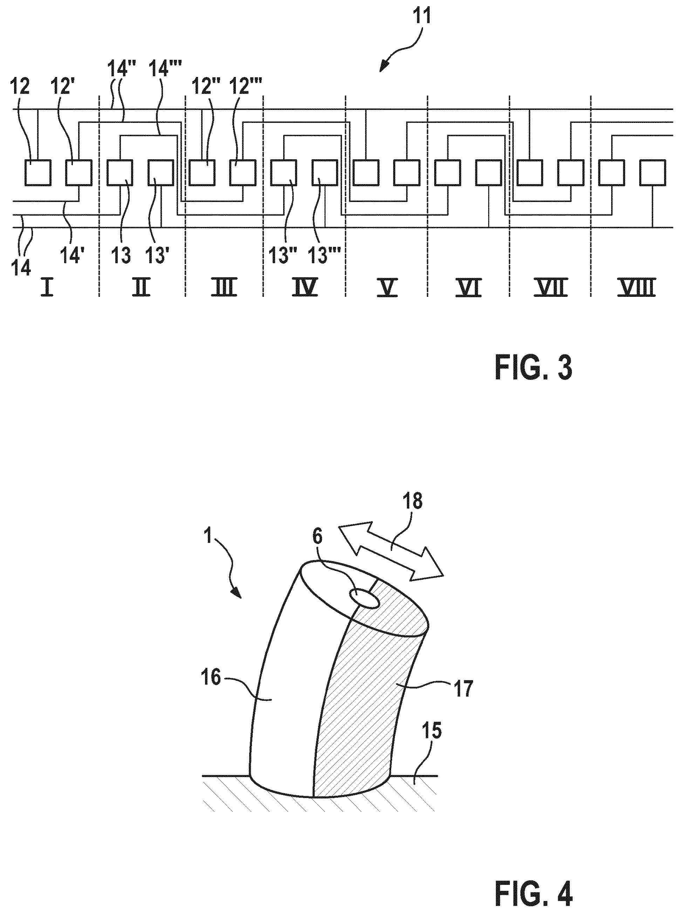

Figur 3 zeigt das Schaltbild 11 einer Ausführungsform mit zwei Elektroden je Windung des schraubenförmigen EAP-Stapels. Eine Gruppe von jeweils zwei in dem Schaltbild aufeinanderfolgende Elektroden 12, 12' und 12", 12"' sowie 13, 13' und 13", 13'" stellen die Elektroden einer Windung des schraubenförmigen EAP-Stapels dar. Die einzelnen Windungen des schraubenförmigen EAP-Stapels sind durch die mit römischen Zahlen gekennzeichneten Abschnitte unterhalb des Schaltbilds angedeutet. Die Elektroden 12, 12' und 12", 12'" repräsentieren die Signalelektroden, während die Elektroden 13, 13' und 13", 13"' die Masseelektroden repräsentieren. Die Masseelektroden und die Signalelektroden sind über elektrisch leitfähige Verbindungen 14 miteinander verbunden.

Ein EAP-Stapel mit einer Anordnung von Elektroden gemäß Fig. 3 ist in Fig. 4 dargestellt, die die Funktion eines derartigen EAP-Stapels veranschaulicht. Der EAP-Stapel 1 ist mit einem seiner beiden Enden an auf einer Unterlage 15 befestigt und weist zwei Ringsektoren 16, 17 auf. Jeder der beiden Ringsektoren umfasst eine Reihe deckungsgleich übereinander angeordneter Elektroden, die durch jeweils eine Lage elektroaktiven Polymers voneinander getrennt sind. Jeder der beiden Ringsektoren 16, 17 entspricht im Querschnitt in etwa dem halben Querschnitt des EAP-Stapels 1.

Durch ein Biegen des freien Endes des EAP-Stapels 1 in der Ebene des Doppelpfeils 18 entlang der durch die Pfeilspitzen angedeuteten Richtungen kann die Bewegung des EAP-Stapels 1 bei generatorischen Betrieb der EAP-Generators in elektrische Energie umgewandelt werden. Durch koordiniertes, im Wesentlichen wechselseitiges Beaufschlagen der Lagen aus elektroaktivem Polymer beider Ringsektoren 16, 17 des EAP-Stapels 1 im aktorischen Betrieb des EAP-Generators ist der EAP-Stapel in den durch den Doppelpfeil 18 dargestellten Richtungen biegbar, das heißt in Richtung der beiden Ringsektoren 16, 17.

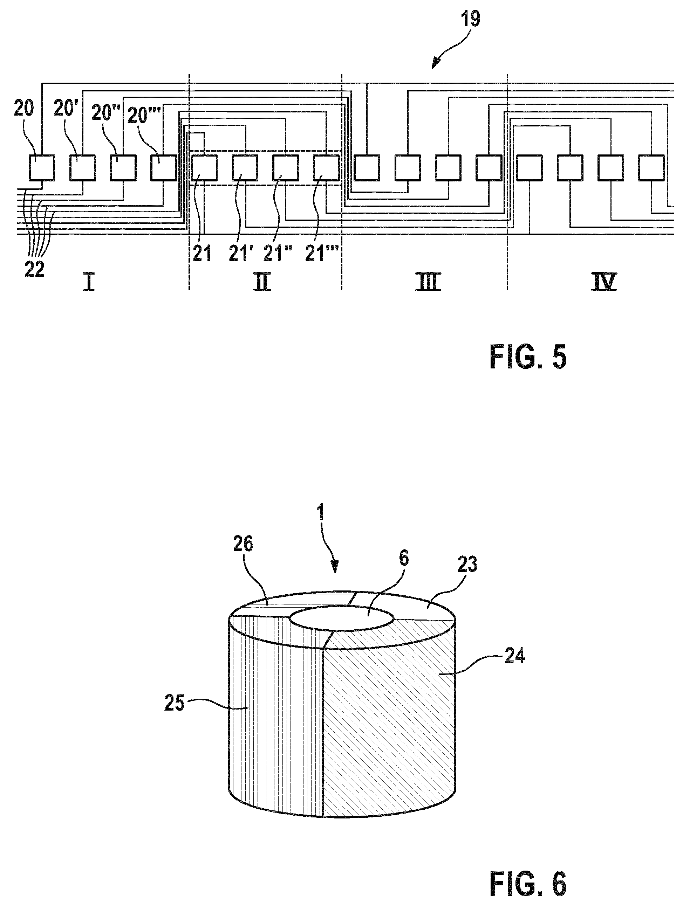

Figur 5 zeigt das Schaltbild 19 einer Ausführungsform mit vier Elektroden je Windung des schraubenförmigen EAP-Stapels. Eine Gruppe von jeweils vier in dem Schaltbild aufeinander folgende Elektroden 20, 20' und 20", 20"' sowie 21, 21' und 21", 21"' stellen die Elektroden einer Windung des schraubenförmigen EAP-Stapels dar. Die einzelnen Windungen des schraubenförmigen EAP-Stapels sind durch die mit römischen Zahlen gekennzeichneten Abschnitte unterhalb des Schaltbilds angedeutet. Die Elektroden 20, 20' und 20", 20'" repräsentieren die Signalelektroden, während die Elektroden 21, 21' und 21", 21 "'die Masseelektroden repräsentieren. Die Masseelektroden und die Signalelektroden sind über elektrisch leitfähige Verbindungen 22 miteinander verbunden.

Ein EAP-Stapel mit einer Anordnung von Elektroden gemäß Fig. 5 ist in Fig. 6 dargestellt, die den Aufbau eines derartigen EAP-Stapels veranschaulicht. Der EAP-Stapel weist vier Ringsektoren 23, 24, 25, 26 auf. Jeder der vier Ringsektoren umfasst eine Reihe deckungsgleich übereinander angeordneter Elektroden, die durch jeweils eine Lage elektroaktiven Polymers voneinander getrennt sind.

Jeder der vier Ringsektoren 23, 24, 25, 26 entspricht im Querschnitt in etwa einem Viertel Querschnitt des EAP-Stapels 1.

Durch ein Biegen des EAP-Stapels in beliebige Richtung kann die Bewegung des EAP-Stapels 1 bei generatorischen Betrieb des EAP-Generators in elektrische Energie umgewandelt werden. Durch koordiniertes Beaufschlagen der Lagen aus elektrokativem Polymer eines jeden Ringsektors 23, 24, 25, 26 im aktorischen Betrieb des EAP-Generators ist der EAP-Stapel in jede beliebige Richtung biegbar. Auf diese Weise lassen sich beispielsweise elektromechanische Finger konstruieren, deren Fingerspitzen kreisförmige Bewegungen ausführen können

## Patentansprüche

1. Verfahren zur Herstellung eines Generators oder Aktuators, **dadurch gekennzeichnet, dass** ein Streifen (2), umfassend eine Lage eines elektroaktiven Polymers (3) und auf diese Lage abschnittweise aufgebrachte Elektroden (4, 8, 10, 12, 13, 20, 21), schraubenförmig derart aufgewickelt wird, dass mehreren als Ringsegmente geformte Elektroden deckungsgleich übereinander angeordnet werden, wobei jeweils zwei übereinander angeordnete Elektroden von zumindest einer Lage elektroaktiven Polymers (3) voneinander getrennt sind.

2. Verfahren gemäß Anspruch 1, **dadurch gekennzeichnet, dass** jeweils zwei übereinander angeordnete Elektroden in Bezug auf den Streifen (2) nicht unmittelbar benachbart sind.

3. Verfahren gemäß Anspruch 1 oder 2, **dadurch gekennzeichnet, dass** jede Wicklung des Streifens (2) derart erfolgt, dass jede zweite, dritte oder vierte Elektrode des Streifens (2) im Stapel (1) deckungsgleich übereinander angeordnet wird.

4. Verfahren gemäß einem der vorhergehenden Ansprüche, **dadurch gekennzeichnet, dass** die Windungen der Schraube miteinander verbunden oder zusammengehalten werden.

5. Verfahren gemäß einem der vorhergehenden Ansprüche, **dadurch gekennzeichnet, dass** der Streifen (2) formschlüssig um einen Stab (7) gewickelt wird, der vorzugsweise einen kreisrunden, ovalen, dreieckigen, viereckigen, mehreckigen oder sternförmigen Querschnitt aufweist.

6. EAP-Stapel (1), der einen schraubenförmig aufgewickelten Streifen (2) umfasst, welcher eine Lage eines elektroaktiven Polymers (3) und auf diese Lage abschnittweise aufgebrachte Elektroden (4, 8, 10, 12, 13, 20, 21) aufweist, und bei dem mehrere, auf dem Streifen (29) nicht unmittelbar benachbarte Elektroden deckungsgleich übereinander angeordnet sind, wobei jeweils zwei übereinander angeordnete als Ringsegmente geformte Elektroden von zumindest einer Lage elektroaktiven Polymers (3) voneinander getrennt sind.

7. EAP-Stapel (1) gemäß Anspruch 6, **dadurch gekennzeichnet, dass** der mindestens eine EAP-Stapel (1) zwei (16, 17), drei oder vier (23, 24, 25, 26) Ringsektoren aufweist, die deckungsgleich übereinander angeordnete Elektroden repräsentieren.

8. EAP-Stapel (1) gemäß einem der Ansprüche 6 oder 7, **dadurch gekennzeichnet, dass** der mindestens eine EAP-Stapel (1) einen Stab (7) aufweist, der im vom inneren Umfang der Schraube begrenzten Hohlraum (6) angeordnet ist und vorzugsweise formschlüssig von der Schraube umgeben ist.

9. EAP-Stapel (1) gemäß Anspruch 8, **dadurch gekennzeichnet, dass** der Stab (7) einen kreisrunden, ovalen, dreieckigen, viereckigen, mehreckigen oder sternförmigen Querschnitt aufweist.

10. EAP-Generator umfassend mindestens einen EAP-Stapel (1) gemäß einem der Ansprüche 6 bis 9.

11. Verwendung eines EAP-Stapels (1) gemäß einem der Ansprüche 6 bis 9 oder eines EAP-Generators gemäß Anspruch 10 zur Erzeugung elektrischer Energie oder als Aktuator.

## Claims

1. Method of producing a generator or actuator, **characterized in that** a strip (2), comprising a layer of electroactive polymer (3) and electrodes (4, 8, 10, 12, 13, 20, 21) applied to parts of said layer, is wound up helically such that a plurality of electrodes, in the form of ring segments, are arranged congruently one above the other, wherein in each case two electrodes arranged one above the other are separated from one another by at least one layer of electroactive polymer (3).

2. Method according to Claim 1, **characterized in that** in each case two electrodes arranged one above the other, as seen in relation to the strip (2), are not directly adjacent.

3. Method according to Claim 1 or 2, **characterized in that** the strip (2) is wound in each case such that every second, third or fourth electrode of the strip (2) in the stack (1) is arranged congruently above another.

4. Method according to one of the preceding claims, **characterized in that** the turns of the helix are connected to one another or held together.

5. Method according to one of the preceding claims, **characterized in that** the strip (2) is wound in a form-fitting manner around a rod (7) of preferably circular, oval, triangular, quadrilateral, polygonal or star-shaped cross section.

6. EAP stack (1) which comprises a helically wound-up strip (2), having a layer of electroactive polymer (3) and electrodes (4, 8, 10, 12, 13, 20, 21) applied to parts of said layer, and in the case of which a plurality of electrodes which are not directly adjacent on the strip (29) are arranged congruently one above the other, wherein in each case two electrodes, in the form of ring segments, arranged one above the other are separated from one another by at least one layer of electroactive polymer (3).

7. EAP stack (1) according to Claim 6, **characterized in that** the at least one EAP stack (1) has two (16, 17), three or four (23, 24, 25, 26) ring sectors, which represent electrodes arranged congruently one above the other.

8. EAP stack (1) according to either of Claims 6 and 7, **characterized in that** the at least one EAP stack (1) has a rod (7), which is arranged in the cavity (6) bounded by the inner circumference of the helix and which is enclosed preferably in a form-fitting manner by the helix.

9. EAP stack (1) according to Claim 8, **characterized in that** the rod (7) is of circular, oval, triangular, quadrilateral, polygonal or star-shaped cross section.

10. EAP generator comprising at least one EAP stack (1) according to one of Claims 6 to 9.

11. Use of an EAP stack (1) according to one of Claims 6 to 9, or of an EAP generator according to Claim 10, for generating electrical energy or as an actuator.

## Revendications

1. Procédé de fabrication d'un générateur ou d'un actionneur, **caractérisé en ce qu'**un ruban (2), comprenant une couche de polymère électro-actif (3) et des électrodes (4, 8, 10, 12, 13, 20, 21) appliquées par sections sur cette couche, est enroulé sous forme hélicoïdale de telle sorte que plusieurs électrodes formées en tant que segments annulaires soient disposées en coïncidence les unes sur les autres, à chaque fois deux électrodes disposées l'une sur l'autre étant séparées l'une de l'autre par au moins une couche de polymère électro-actif (3).

2. Procédé selon la revendication 1, **caractérisé en ce qu'**à chaque fois deux électrodes disposées l'une sur l'autre ne sont pas directement adjacentes par rapport au ruban (2).

3. Procédé selon la revendication 1 ou 2, **caractérisé en ce que** chaque enroulement du ruban (2) se produit de telle sorte que chaque deuxième, troisième ou quatrième électrode du ruban (2) soit disposée en coïncidence l'une sur l'autre dans l'empilement (1).

4. Procédé selon l'une quelconque des revendications précédentes, **caractérisé en ce que** les enroulements de l'hélice sont connectés ou retenus les uns aux autres.

5. Procédé selon l'une quelconque des revendications précédentes, **caractérisé en ce que** le ruban (2) est enroulé autour d'une barre (7) avec engagement par correspondance géométrique, laquelle barre présente une section transversale de préférence ronde circulaire, ovale, triangulaire, rectangulaire, polygonale ou stellaire.

6. Empilement EAP (1), qui comprend un ruban (2) enroulé sous forme hélicoïdale, qui présente une couche d'un polymère électro-actif (3) et des électrodes (4, 8, 10, 12, 13, 20, 21) appliquées par sections sur cette couche, et dans lequel plusieurs électrodes non directement adjacentes sur le ruban (29) sont disposées les unes sur les autres en coïncidence, à chaque fois deux électrodes d'au moins une couche de polymère électro-actif (3) disposées l'une sur l'autre et formées en tant que segments annulaires étant séparées l'une de l'autre.

7. Empilement EAP (1) selon la revendication 6, **caractérisé en ce que** l'au moins un empilement EAP (1) présente deux (16, 17), trois ou quatre (23, 24, 25, 26) secteurs annulaires, lesquels représentent des électrodes disposées en coïncidence les unes sur les autres.

8. Empilement EAP (1) selon l'une quelconque des revendications 6 ou 7, **caractérisé en ce que** l'au moins un empilement EAP (1) présente une barre (7) qui est disposée dans la cavité (6) limitée par la périphérie intérieure de l'hélice et qui est entourée de préférence par engagement par correspondance géométrique par l'hélice.

9. Empilement AEP (1) selon la revendication 8, **caractérisé en ce que** la barre (7) présente une section transversale ronde circulaire, ovale, triangulaire, rectangulaire, polygonale ou stellaire.

10. Générateur EAP comprenant au moins un empilement EAP (1) selon l'une quelconque des revendications 6 à 9.

11. Utilisation d'un empilement EAP (1) selon l'une quelconque des revendications 6 à 9, ou d'un générateur EAP selon la revendication 10, pour générer de l'énergie électrique ou en tant qu'actionneur.
